(19) Europäisches Patentamt
European Patent Office
Office européen des brevets

(11) EP 2 099 276 A1

(12) EUROPEAN PATENT APPLICATION

(43) Date of publication:
09.09.2009 Bulletin 2009/37

(51) Int Cl.:
*H05K 7/20* (2006.01)

(21) Application number: 09154088.0

(22) Date of filing: 02.03.2009

(84) Designated Contracting States:
AT BE BG CH CY CZ DE DK EE ES FI FR GB GR HR HU IE IS IT LI LT LU LV MC MK MT NL NO PL PT RO SE SI SK TR
Designated Extension States:
AL BA RS

(30) Priority: 05.03.2008 KR 20080020570

(71) Applicant: Samsung SDI Co., Ltd.
Suwon-si
Gyeonggi-do (KR)

(72) Inventors:
• Lee, So-Ra
Gyeonggi-do (KR)

• Kim, Jae-Myung
Gyeonggi-do (KR)
• Kim, Yoon-Jin
Gyeonggi-do (KR)
• Moon, Hee-Sung
Gyeonggi-do (KR)
• Joo, Kyu-Nam
Gyeonggi-do (KR)
• Park, Hyun-Ki
Gyeonggi-do (KR)

(74) Representative: Gulde Hengelhaupt Ziebig & Schneider
Patentanwälte - Rechtsanwälte
Wallstrasse 58/59
10179 Berlin (DE)

(54) **Flat panel display apparatus**

(57) A flat panel display apparatus (1) includes a display unit (100) for displaying images, a first semiconductor (10) and a second semiconductor (20) electrically connected to the display unit (100), and a heat sink (30) electrically connected to the first semiconductor (10) and to the second semiconductor (20).

FIG. 3

EP 2 099 276 A1

**Description**

**CROSS-REFERENCE TO RELATED APPLICATION**

This application claims priority to and the benefit of Korean Patent Application No. 10-2008-0020570, filed on March 5, 2008, in the Korean Intellectual Property Office, the entire disclosure of which is incorporated herein by reference.

**BACKGROUND OF THE INVENTION**

**1. Field of the Invention**

The present invention relates to a flat panel display apparatus, and more particularly, to a flat panel display apparatus having a heat dissipation mechanism.

**2. Description of the Related Art**

Recently, flat panel display apparatuses have been intensively developed. Examples of flat panel display apparatuses include a liquid crystal display (LCD), a plasma display apparatus, a field emission display device, and a vacuum fluorescent display device.

An electron emission element included in such flat panel display apparatuses may have a hot cathode or a cold cathode as an electron emission source. Examples of electron emission elements using a cold cathode include a field emission device (FED) type electron emission element, a surface conduction emitter (SCE) type electron emission element, a metal insulator metal (MIM) type electron emission element, and a ballistic electron surface emitting (BSE) type electron emission element.

In the FED type electron emission element, electrons are easily emitted due to an electric field difference in a vacuum state when a material having a small work function or a large beta function is used to form an electron emission source. A device in which a tip structure having a sharp top end formed of molybdenum (Mo), silicon (Si), etc., or a carbon-based material such as graphite, diamond like carbon (DLC), etc., or a nano material such as nano tube or nano wire is used to form an electron emission source has been developed.

The FED type electron emission element may be of a top gate type and an under gate type according to the arrangement of a cathode and a gate electrode, or may be a diode, a triode, a tetrode, etc., according to the number of electrodes. In a conventional electron emission element, electrons are emitted from an electron emission source by an electric field formed between a cathode and a gate electrode. Electrons are emitted from an electron emission source disposed around an electrode that acts as a negative electrode between the cathode and the gate electrode. The emitted electrons proceed toward an electrode that acts as a positive electrode at an initial stage, are led by a strong electric field of an anode, and are accelerated toward a phosphor layer.

Due to a large amount of current, much heat is generated by the anode of the conventional FED type electron emission element. As such, the temperature of the entire panel increases and thus, several problems may occur. For example, since the anode may reach a high temperature of 100°C or greater due to the generated heat, a glass substrate may be destroyed by thermal expansion. In addition, other elements that have low heat resistance are affected so that the defective rate of a product increases. In particular, since light is emitted from the anode and a front substrate on which the anode is installed, a heat-dissipating plate may not be directly installed on a flat panel display apparatus and, therefore, the flat panel display apparatus may not be able to be effectively cooled.

In order to solve these problems, in the prior art, the flat panel display apparatus is cooled by an external cooling fan. However, an external fan does not always provide effective cooling and causes the manufacturing costs of a flat panel display apparatus to be relatively high.

**SUMMARY OF THE INVENTION**

Aspects of the present invention provide a flat panel display apparatus in which heat generated by an anode and a front substrate on which the anode is installed can be effectively cooled.

A flat panel display apparatus includes a display unit for displaying images, a first semiconductor and a second semiconductor electrically connected to the display unit, and a heat sink electrically connected to the first semiconductor and to the second semiconductor. The display unit may comprise an electron emission element comprising a rear substrate, a first electrode on the rear substrate, a second electrode electrically insulated from the first electrode, and an electron emission source electrically connected to the first electrode. Furthermore, the display unit may include a front panel comprising a front substrate, a phosphor layer on the front substrate being opposite to the electron emission source, and a third electrode adapted to accelerate electrons emitted from the electron emission element toward the phosphor layer. Preferably, the first semiconductor and the second semiconductor are electrically connected to the front panel.

The heat sink may be opposite to the display unit and/or may be adapted to dissipate heat generated by the display unit away from the display unit. Light generated by the display unit may be emitted in a direction away from the heat sink.

The first semiconductor may be a P-type semiconductor and the second semiconductor may be an N-type semiconductor. Further, the display unit and the heat sink may comprise different conductive materials and/or the display unit may be connected to the first semiconductor and to the second semiconductor via a metal conducting wire. The metal conducting wire may be connected to a non-effective region of the display unit that does not display images. The heat sink may be a Peltier heat sink.

**BRIEF DESCRIPTION OF THE DRAWINGS**

The above and other aspects and advantages of the present invention will become more apparent by describing in detail exemplary embodiments thereof with reference to the attached drawings in which:

FIG. 1 is a partial perspective view showing a schematic configuration of an electron emission type backlight unit having an electron emission source according to an embodiment of the present invention.

FIG. 2 is a cross-sectional view taken along line II-II of FIG. 1.

FIG. 3 is a plan view showing a schematic configuration of a flat panel display apparatus according to an embodiment of the present invention.

**DETAILED DESCRIPTION**

The present invention will now be described more fully with reference to the accompanying drawings, in which exemplary embodiments of the invention are shown.

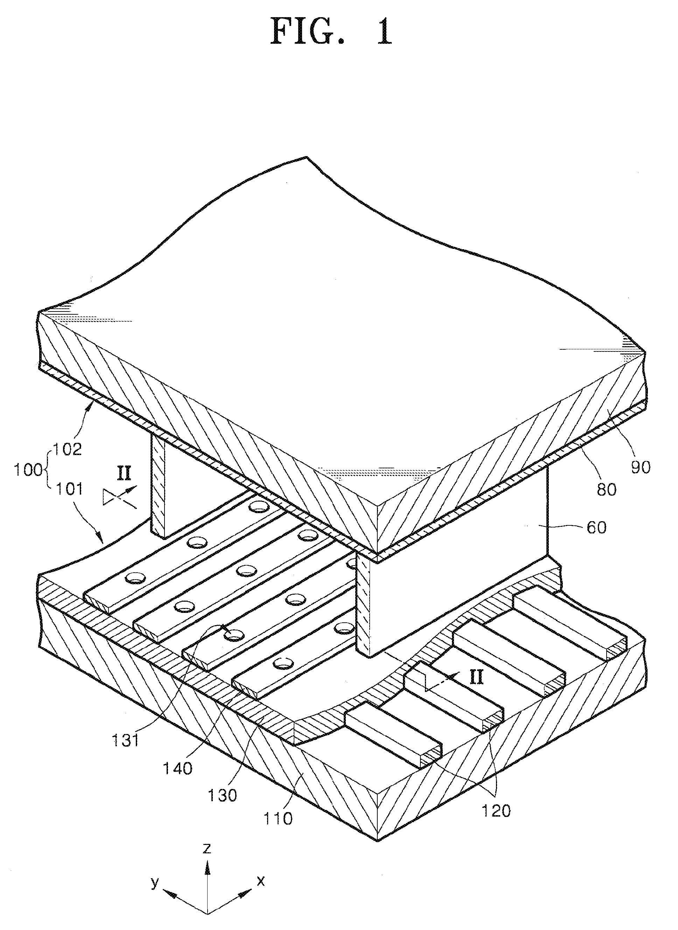

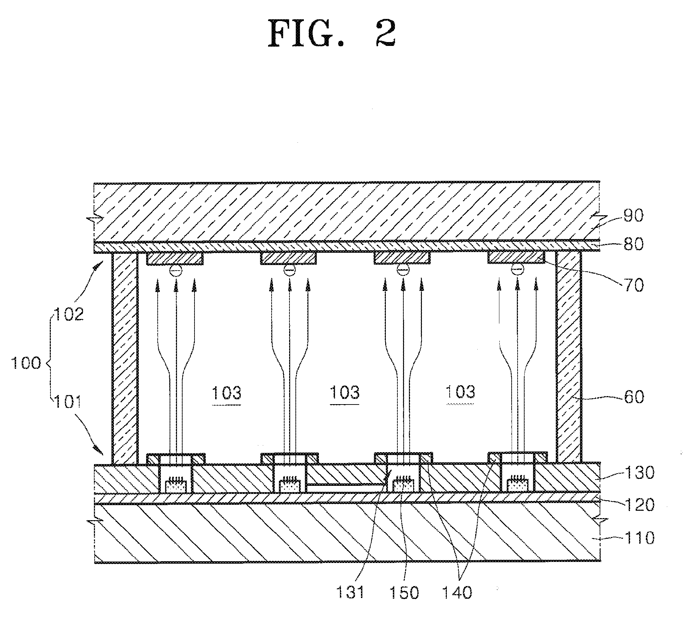

FIG. 1 is a partial perspective view showing the schematic configuration of an electron emission type backlight unit having an electron emission source according to an embodiment of the present invention, and FIG. 2 is a cross-sectional view taken along line II-II of FIG. 1.

As illustrated in FIGS. 1 and 2, an electron emission type backlight unit 100 comprises electron emission elements 101 disposed in parallel, a front panel 102, and a spacer 60 that maintains a distance between the electron emission element 101 and the front panel 102. An emission space 103 formed between the electron emission elements 101 and the front panel 102 is in a vacuum state.

Each of the electron emission elements 101 comprises a first substrate 110, first electrodes 120, an insulator layer 130, second electrodes 140, and an electron emission source 150 (FIG. 2).

The first electrodes 120 and the second electrodes 140 are disposed on the first substrate 110 to cross one another, and the insulator layer 130 is disposed between the second electrodes 140 and the first electrodes 120 to electrically insulate the second electrodes 140 and the first electrodes 120. Electron emission source holes 131 are formed in regions in which the second electrodes 140 cross the first electrodes 120, and an electron emission source 150 is disposed in the electron emission source holes 131 (FIG. 2).

The first substrate 110 may be a plate-shaped member having a thickness. Quartz glass, glass containing an impurity such as a small amount of Na, plate glass, a $SiO_2$-coated glass substrate, an aluminum oxide or a ceramic substrate may be used as the first substrate 110. In addition, a flexible material may be used to form a flexible display apparatus.

The first electrodes 120 and the second electrodes 140 may be generally formed of an electrically conductive material, for example, Al, Ti, Cr, Ni, Au, Ag, Mo, W, Pt, Cu, Pd, etc., or an alloy thereof, a printed conductor comprised of glass and metal, such as Pd, Ag, $RuO_2$ or Pd-Ag, or a metal oxide, a transparent conductor, such as $In_2O_3$ or $SnO_2$, or a semiconductor material such as polysilicon, etc.

The insulator layer 130 insulates the first substrate 110 from the second electrodes 140. The insulator layer 130 may be generally formed of an insulating material. For example, the insulating material may be a silicon oxide, a silicon nitride, a frit, among others. The frit may be a $PbO$-$SiO_2$-based frit, a $PbO$-$B_2O_3$-$SiO_2$-based frit, a $ZnO$-$SiO_2$-based frit, a $ZnO$-$B_2O_3$-$SiO_2$-based frit, a $Bi_2O_3$-$SiO_2$-based frit, or a $Bi_2O_3$-$B_2O_3$-$SiO_2$-based frit. However, the present invention is not limited to these materials.

The electron emission source 150 includes an electron emission material. Carbon nano tubes (CNTs) having a small work function and a large beta function may be used as the electron emission material. In particular, CNTs have an excellent electron emission characteristic and are easily driven by a low voltage, and thus are often used to form large-scale devices. However, the present invention is not limited to CNTs, and a carbon-based material such as graphite, diamond, diamond-like carbon (DLC), etc., or a nano material such as nano tube, nano wire, or nano rod, etc., may also be used as the electron emission material. Alternatively, the electron emission material may include carbide-driven carbon.

The front panel 102 comprises a second substrate 90 that transmits visible rays, a phosphor layer 70 (FIG. 2) disposed on the second substrate 90 and excited by electrons emitted from the electron emission elements 101 to generate visible rays, and third electrodes 80 that accelerate the electrons emitted from the electron emission elements 101 toward the phosphor layer.

The second substrate 90 may be formed of the same material as the first substrate 110 as described above, and may transmit visible rays.

The third electrodes 80 may be formed of the same material as the first electrodes 120 or the second electrodes 140 as described above.

The phosphor layer 70 is formed of a cathode luminescence (CL) type phosphor that is excited by accelerated electrons and generates visible rays. Phosphor that can be used to form the phosphor layer 70 may be phosphor for red light including $SrTiO_3$:Pr, $Y_2O_3$:Eu or $Y_2O_3S$:Eu, phosphor for green light including $Zn(Ga, Al)_2O_4$:Mn, $Y_3(Al, Ga)_5O_{12}$:Tb, $Y_2SiO_5$:Tb, ZnS:Cu, Al, etc., or phosphor for blue light including $Y_2SiO_5$:Ce, $ZnGa_2O_4$, ZnS:Ag, Al, etc. However, the present invention is not limited to the above-mentioned phosphors.

In order to operate the electron emission type backlight unit 110 according to an embodiment of the present invention, a space between the phosphor layer 70 and the electron emission elements 101 is maintained in a vacuum state. Accordingly, a glass frit that seals a vacuum space with the spacer 60 that maintains a distance between the phosphor layer 70 and the electron emission elements 101 may be further used. The glass frit is disposed around the vacuum space to seal it.

The electron emission type backlight unit 100 having the above structure operates in the following manner. A negative (-) voltage is applied to the first electrodes 120 disposed in the electron emission elements 101 and a positive (+) voltage is applied to the second electrodes 140 so that electrons are emitted from the electron emission source 150 toward the second electrodes 140 due to an electric field formed between the first electrodes 120 and the second electrodes 140. In this case, when a larger positive voltage is applied to the third electrodes 80 than to the second electrodes 140, the electrons emitted from the electron emission source 150 are accelerated toward the third electrodes 80. The electrons excite the phosphor layer 70 adjacent to the third electrodes 80 so that visible rays are generated therefrom. The emission of electrons may be controlled by a voltage applied to the second electrodes 140.

The negative voltage is applied to the first electrodes 120 to create a proper potential difference required for electron emission between the first electrodes 120 and the second electrodes 140.

The electron emission type backlight unit 100 illustrated in FIGS. 1 and 2 may be a backlight unit for a non-emissive display device such as a thin film transistor-liquid crystal display (TFT-LCD) used as a surface light source. In addition, in order to generate visible rays from a surface light source and to create images, or in order to constitute a backlight unit having a dimming function, the first electrodes 120 and the second electrodes 140 of the electron emission elements 101 may be disposed to cross one another. Accordingly, one of the first electrodes 120 and the second electrodes 140 are formed to have a main electrode portion and a branch electrode portion. The main electrode portion crosses other electrodes, and the branch electrode portion protrudes from the main electrode portion and is disposed to oppose other electrodes. An electron emission layer may be formed in the branch electrode portion or a portion of the main electrode portion that faces the branch electrode portion.

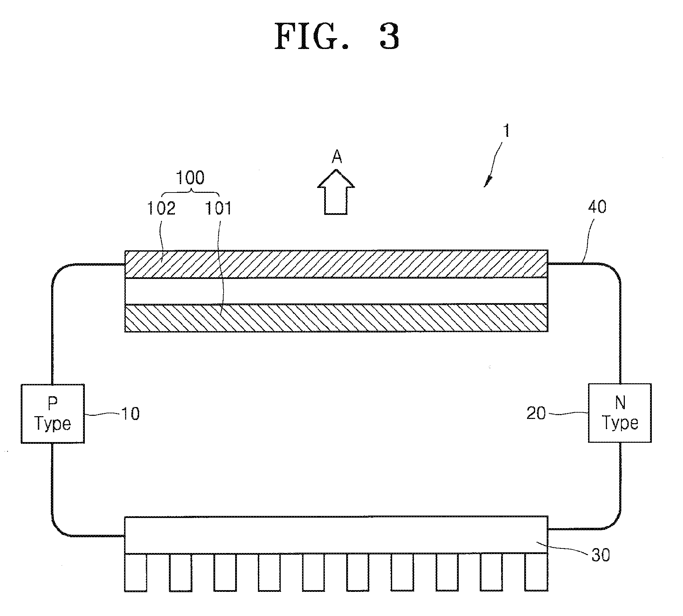

FIG. 3 is a plan view showing the schematic configuration of a flat panel display apparatus according to an embodiment of the present invention. Referring to FIG. 3, a flat panel display apparatus 1 according to the present embodiment comprises an electron emission type backlight unit 100, a first semiconductor 10, a second semiconductor 20, a heat sink 30, and a metal conducting wire 40.

High temperatures are generated by third electrodes (anodes) of a conventional FED type electron emission element due to a large amount of current and several problems occur as described previously. Due to a large amount of current, much heat is generated by the anode of a conventional FED type electron emission element, thereby causing the temperature of the entire panel to increase and leading to several problems, as described above.

In embodiments of the present invention, however, heat generated in a front side of the flat panel display apparatus can be effectively dissipated toward a rear side of the flat panel display apparatus by using a thermoelectric device.

Specifically, a thermoelectric module electrically connects n-type or p-type thermoelectric semiconductors in series and thermally connects them in parallel. In one embodiment, the thermoelectric module may have an upside down π-tpye (aΓ -shape) to serially circuit bond a p-type element and an n-type element to metal electrodes. When a current flows through from the n-type element to the p-type element so that electrodes at two branching end parts of the p-n couple are negative and positive electrodes, respectively, holes in the p-type element move toward a negative electrode and electrons in the n-type element move toward a positive electrode. As such, since the holes and the electrons are heated from p-n junction electrodes and are moved to the other branching end electrode, an upper junction is cooled and absorbs heat from the periphery and a lower branching end dissipates heat. Such a phenomenon is referred to as the Peltier effect, and is used as a heat pipe for cooling.

That is, the Peltier effect occurs when a direct current flows through a circuit formed of two different metals having the same shape, and heat is absorbed at one junction and heat is dissipated at other junction. When the direction of the current is reversed, heat absorption and heat dissipation are reversed as well. Thus, when an electrical load is applied to two different metals having connected cross-sections, heat dissipation and cooling occur simultaneously at each cross-section of the metals and can be expressed by the following equation:

$$\mid Q_p \mid = \alpha ab * T_j * I = \pi * I$$

where I $Q_p$ I is an absolute value of heat generated per unit time, $\alpha ab$ is a relative thermal conducting capability of two metals a and b according to the ambient temperature, $\pi = \alpha ab * T_j$ is a Peltier coefficient, and I is a current.

Consequently, in the Peltier effect, heat dissipation and absorption occur when a current flows through a junction between two different materials. If heat is generated when a current flows in one direction, heat is absorbed when the current flows in an opposite direction. Thus, the Peltier effect is reversible. If a current flows through the junction, heat generation or absorption due to the Peltier effect occurs in addition to the Joule heat effect occurring when a current flows through a conductor.

Referring back to FIG. 3, the third electrodes 80 of the front panel 102 of the electron emission type backlight unit 100 may be generally formed of an electrically conductive material, as described above. Examples of electrically conductive materials include a metal such as Al, Ti, Cr, Ni, Au, Ag, Mo, W, Pt, Cu, or Pd, etc., or an alloy thereof, a printed conductor comprised of glass and a metal, such as Pd, Ag, $RuO_2$ or Pd-Ag, or a metal oxide, a transparent conductor, such as $In_2O_3$ or $SnO_2$, or a semiconductor material such as polysilicon, etc. High temperature heat is generated in the third electrodes 80 due to a large amount of current.

The heat sink 30 may be formed at a rear side of the flat panel display apparatus 1. More generally, the heat sink 30 may be formed at a side opposite to the direction in which light is generated (see arrow A of FIG. 3) in the electron emission type backlight unit 100 of the flat panel display apparatus 1. In other words, in the transmission type flat display panel apparatus 1 in which light generated in the electron emission type backlight unit 100 is emitted through the front panel 102, an additional heat sink cannot be attached to the third electrodes 80 to dissipate heat generated by the third electrodes 80. As such, according to an embodiment of the present invention, the heat sink 30 is disposed at the rear side of the flat panel display apparatus 1. The first semiconductor 10, the second semiconductor 20, and the metal conducting wire 40 connecting the first semiconductor 10 and the second semiconductor 20 are provided between the front panel 102 and the heat sink 30. The heat sink 30 may be formed of a conductive material different from the material of the third electrodes 80 in order to generate the Peltier effect. In one embodiment, the heat sink 30 is a Peltier heat sink.

The first semiconductor 10 is formed to be connected to one end of the third electrodes 80 of the front panel 102 and one end of the heat sink 30 via the metal conducting wire 40.

Similarly, the second semiconductor 20 is formed to be connected to another end of the third electrodes 80 of the front panel 102 and another end of the heat sink 30 via the metal conducting wire 40.

The ends of the third electrodes 80 to which the metal conducting wire 40 is connected may be regions that do not transmit light, for example, regions of a black matrix. Due to the above structure, the effect for cooling heat generated in the third electrodes 80 can be achieved without loss of emitted light.

As noted above, the first semiconductor 10 may be a P-type semiconductor, and the second semiconductor 20 may be an N-type semiconductor. In this case, when a current is applied to the first semiconductor 10 from the second semiconductor 20, due to the Peltier effect, the third electrodes 80 act as a cooling unit, and the heat sink 30 acts as a heating unit. Thus, heat generated by the third electrodes 80 is transferred to the heat sink 30 and is dissipated toward the outside of the flat panel display apparatus 1.

The first semiconductor 10 and the second semiconductor 20 may be disposed on both side surfaces of the flat panel display apparatus 1, as illustrated in FIG. 3.

Due to the above structure of embodiments of the present invention, heat generated in the third electrodes and in the front substrate in which the third electrodes are installed can be effectively dissipated. Thus, the life span and various characteristics of the flat panel display apparatus 1 can be improved. In addition, since heat is controlled using an electronic device, precise temperature control can be achieved by embodiments of the present invention. In addition, rapid cooling can be performed after power is supplied, and local cooling can also be performed. Furthermore, the flat panel display apparatus according to embodiments of the present invention can be operated in any position or direction regardless of the device's orientation. Furthermore, the cooling unit can be downsized and lightened, and low noise and low vibration cooling can be implemented.

The electron emission type backlight 100 is illustrated as an emission unit in which light is generated, but the present invention is not limited thereto. In other words, the present invention can be applied to any flat panel display apparatus in which heat is generated, such as an LCD or a plasma display apparatus, and in particular, a transmission type flat panel display apparatus.

In the flat panel display apparatus according to embodiments of the present invention, heat generated by the anode and the front substrate in which the anode is installed can be effectively dissipated.

While the present invention has been particularly shown and described with reference to exemplary embodiments thereof, it will be understood by those of ordinary skill in the art that various changes in form and details may be made therein without departing from the scope of the present invention as defined by the following claims.

**Claims**

1. A flat panel display apparatus (1) comprising:

     a display unit (100) for displaying images;
     a first semiconductor (10) and a second semiconductor (20) electrically connected to the display unit (100); and
     a heat sink (30) electrically connected to the first semiconductor (10) and to the second semiconductor (20).

2. The flat panel display apparatus of claim 1, wherein the heat sink (30) is located on a side of the display unit (100) opposed to the side which is emitting light.

3. The flat panel display apparatus of one of the preceding claims, wherein the heat sink (30) is adapted to dissipate heat generated by the display unit (100) away from the display unit (100).

4. The flat panel display apparatus of one of the preceding claims, wherein the first semiconductor (10) is a P-type semiconductor and the second semiconductor (20) is an N-type semiconductor.

5. The flat panel display apparatus of one of the preceding claims, wherein the display unit (100) and the heat sink (30) comprise different conductive materials.

6. The flat panel display apparatus of one of the preceding claims, wherein the display unit (100) is connected to the first semiconductor (10) and to the second semiconductor (20) via a metal conducting wire (40).

7. The flat panel display apparatus of claim 6, wherein the metal conducting wire (40) is connected to a non-emitting region of the display unit (100) that is not adapted to display images.

8. The flat panel display apparatus of one of the preceding claims, wherein the heat sink (30) is a Peltier heat sink.

9. The flat panel display apparatus of one of the preceding claims, further comprising:

> an electron emission element (101) comprising a rear substrate (110), a first electrode (120) on the rear substrate (110), a second electrode (140) electrically insulated from the first electrode (120), and an electron emission source (150) electrically connected to the first electrode (120);
> a front panel (102) comprising a front substrate (90), a phosphor layer (70) located on a surface of the front substrate (90) facing the electron emission source (150), and a third electrode (80) adapted to accelerate electrons emitted from the electron emission element (150) toward the phosphor layer (70), and
> wherein the first semiconductor (10) and the second semiconductor (20) are electrically connected to the front panel (102)

10. The flat panel display apparatus of claim 9, wherein the third electrode (80) and the heat sink (30) comprise different conductive materials.

# FIG. 1

# FIG. 2

# FIG. 3

Europäisches
Patentamt

European
Patent Office

Office européen
des brevets

**EUROPEAN SEARCH REPORT**

Application Number

EP 09 15 4088

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 507 328 B1 (LEE JOHN K [US]) 14 January 2003 (2003-01-14) * column 3, line 34 - column 4, line 31; figures 1,2 * ----- | 1-10 | INV. H05K7/20 |
| X | JP 2005 024808 A (HITACHI LTD) 27 January 2005 (2005-01-27) * abstract * ----- | 1-10 | |
| X | JP 2006 293062 A (SHARP KK) 26 October 2006 (2006-10-26) * abstract * ----- | 1-10 | |
| A | US 2007/285843 A1 (TRAN BAO Q [US]) 13 December 2007 (2007-12-13) * paragraph [0195] * * paragraph [0225] - paragraph [0233]; figure 11 * ----- | 1-10 | |
| | | | TECHNICAL FIELDS SEARCHED (IPC) H05K H01J |

The present search report has been drawn up for all claims

| Place of search | Date of completion of the search | Examiner |
|---|---|---|
| Munich | 14 May 2009 | Dobbs, Harvey |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

10

## ANNEX TO THE EUROPEAN SEARCH REPORT
## ON EUROPEAN PATENT APPLICATION NO.

EP 09 15 4088

This annex lists the patent family members relating to the patent documents cited in the above-mentioned European search report.
The members are as contained in the European Patent Office EDP file on
The European Patent Office is in no way liable for these particulars which are merely given for the purpose of information.

14-05-2009

| Patent document cited in search report | | Publication date | Patent family member(s) | | Publication date |
|---|---|---|---|---|---|
| US 6507328 | B1 | 14-01-2003 | US | 2003137474 A1 | 24-07-2003 |
| JP 2005024808 | A | 27-01-2005 | NONE | | |
| JP 2006293062 | A | 26-10-2006 | NONE | | |
| US 2007285843 | A1 | 13-12-2007 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020080020570